# EUROPEAN PATENT APPLICATION

(11) **EP 3 561 586 A1**
(43) Date of publication of application: **30.10.2019**
(21) Application number: 16924633.7
(22) Date of filing: 24.12.2016
(51) Int. Cl.: G02F 1/1362

(54) **THIN-FILM TRANSISTOR ARRAY SUBSTRATE, LOW TEMPERATURE POLYSILICON THIN-FILM TRANSISTOR, AND METHOD FOR MANUFACTURING SAME**

(71) Applicant: Shenzhen Royole Technologies Co., Ltd., Shenzhen, Guangdong 518172 (CN)
(72) Inventor: CHEN, Xiaoming, Shenzhen Guangdong 518052 (CN)
(74) Representative: Mewburn Ellis LLP
(86) International application number: PCT/CN2016/111868
(87) International publication number: WO 2018/112950

(57) **Abstract**

The present disclosure provides a low temperature poly-silicon thin film transistor. The low temperature poly-silicon thin film transistor includes a substrate (10), a poly-silicon layer (11) formed at a surface of the substrate (10), an insulating layer (12), a gate electrode (13), a first control electrode (14), a second control electrode (15), a source electrode (16), and a drain electrode (17). The insulating layer (12) covers the poly-silicon layer (11). The first control electrode (14), the second control electrode (15), and the gate electrode (13) are formed at the insulating layer (12). The first control electrode (14), the second control electrode (15), and the gate (13) are formed at the insulating layer (12). A gap between the first control electrode (14) and the gate electrode (13) and a gap between the second control electrode (15) and the gate electrode (13) correspond to offset regions (111) of the poly-silicon layer (11). Two heavily doped regions (112) formed at the poly-silicon layer are respectively located besides the first control electrode (14) and the second control electrode (15) away from the offset regions (111). The source electrode (16) and the drain electrode (17) are respectively formed at the heavily doped regions (112). The present disclosure further provides a low temperature poly-silicon thin film transistor array substrate.

## Description

### TECHNICAL FIELD

The present disclosure relates to the technical field of manufacturing thin film transistors, and more particularly relates to a low temperature poly-silicon thin film transistor, a method for manufacturing the low temperature poly-silicon thin film transistor, and a low temperature poly-silicon thin film transistor array substrate.

### BACKGROUND

Low temperature poly-silicon thin film transistors are widely used in small and medium-sized display panels due to high mobility of carriers thereof. When a voltage difference between a gate electrode and a drain electrode of an existing poly-silicon thin film transistor is large, impact ionization, band-to-band tunneling, and the like may occur in a semiconductor layer of the existing poly-silicon thin film transistor, resulted in increased current leakage or even breakdown.

To solve this problem, a symmetric offset structure of the poly-silicon thin film transistor has been proposed. However, since the offset length has a significant influence on the electrical characteristics of the poly-silicon thin film transistor, deviations of the poly-silicon thin film transistor during doping alignment or source-drain alignment may affect electrical characteristics of the poly-silicon thin film transistor.

### SUMMARY

Embodiments of the present disclosure provide a low temperature poly-silicon thin film transistor and a method for manufacturing the low temperature poly-silicon thin film transistor, which improve the electrical characteristics of the low temperature poly-silicon thin film transistor.

A low temperature poly-silicon thin film transistor of the present disclosure includes a substrate, a poly-silicon layer formed at a surface of the substrate, an insulating layer, a gate electrode, a first control electrode, a second control electrode, a source electrode, and a drain electrode. The insulating layer covers the poly-silicon layer. The first control electrode, the second control electrode, and the gate electrode are formed at the insulating layer. A gap is defined between the first control electrode and the gate electrode. A gap is defined between the second control electrode and the gate electrode. The gaps correspond to two offset regions of the poly-silicon layer, respectively. Two heavily doped regions are formed at the poly-silicon layer and respectively located at a side of the first control electrode away from the offset regions and a side of the second control electrode away from the offset regions. The source electrode and the drain electrode are respectively formed at the two heavily doped regions.

Therein, the two offset regions are lightly doped regions.

Therein, the first control electrode is connected to an external signal line, and the second control electrode is connected to another external signal line or connected to the drain electrode.

Therein, the gate electrode, the first control electrode, and the second control electrode are formed in the same operation.

Therein, a width of the first control electrode is greater than or equal to a width of the gap between the first control electrode and the gate electrode, and a width of the second control electrode is greater than or equal to a width of the gap between the second control electrode and the gate electrode.

A method for manufacturing the low temperature poly-silicon thin film transistor of the present disclosure includes: forming a poly-silicon layer, an insulating base layer, and a first metal layer on a substrate in sequence; patterning the first metal layer to form a gate electrode, a first control electrode, and a second control electrode, and the gate electrode, the first control electrode and the gate electrode spaced apart from each other, and the second control electrode and the gate electrode spaced apart from each other; forming an insulating base layer by the insulating base layer with the patterned first metal layer, the insulating layer defining two offset regions, a source region, and a drain region, the offset regions located at the poly-silicon layer, one of the offset regions located between the first control electrode and the gate electrode, the other of the offset regions located between the second control electrode and the gate electrode, the source region and the drain region respectively located a side of the first control electrode away from the offset regions and a side of the second control side away from the offset regions; ion doping the source region and the drain region to form heavily doped regions; and forming a source electrode and a drain electrode in the heavily doped regions, respectively.

Therein, the forming an insulating base layer by the insulating base layer with the patterned first metal layer, the insulating layer defining two offset regions, a source region, and a drain region, includes defining the offset regions, the source region, and the drain region with the position of the first control electrode and the position of the second control electrode as a reference.

Therein, the method further includes lightly doping the offset regions before ion doping the source region and the drain region, to form heavily doped regions.

Therein, the low temperature poly-silicon thin film transistor further forms external signal lines operated to connect the first control electrode, or to connect the first control electrode and the second control electrode.

A thin film transistor array substrate of the present disclosure includes a low temperature poly-silicon thin film transistor. The low temperature poly-silicon thin film transistor includes a substrate, a poly-silicon layer formed at a surface of the substrate, an insulating layer, a gate electrode, a first control electrode, a second control electrode, a source electrode, and a drain electrode. The insulating layer covers the poly-silicon layer. The first control electrode, the second control electrode, and the gate electrode are formed at the insulating layer. A gap is defined between the first control electrode and the gate electrode. A gap is defined between the second control electrode and the gate electrode. The gaps correspond to two offset regions of the poly-silicon layer. Two heavily doped regions are formed at the poly-silicon layer and respectively located at a side of the first control electrode away from the offset regions and a side of the second control electrode away from the offset regions. The source electrode and the drain electrode are respectively formed at the two heavily doped regions.

Therein, the two offset regions are lightly doped regions.

Therein, the first control electrode is connected to an external signal line, and the second control electrode is connected to another external signal line or connected to the drain electrode.

Therein, the gate electrode, the first control electrode, and the second control electrode are formed in the same operation.

Therein, a width of the first control electrode is greater than or equal to a width of the gap between the first control electrode and the gate electrode, and a width of the second control electrode is greater than or equal to a width of the gap between the second control electrode and the gate electrode.

The low temperature poly-silicon thin film transistor described in the present disclosure simultaneously forms the control electrodes at two sides of the gate electrode when forming the gate electrode, and the two control electrodes may reduce the resistance of the low temperature poly-silicon thin film transistor. In this way, not only the electrical characteristics of the thin film transistor may be changed, but also the offset regions, the source region, and the drain region are limited through the two control electrodes. Therefore, the position self-alignment is realized when doping the poly-silicon layer, and the position offset affecting the length of the offset regions is avoided.

### BRIEF DESCRIPTION OF THE DRAWINGS

In order to more clearly illustrate the technical solution of the embodiments of the present disclosure, the accompanying drawings required for describing the embodiments will be briefly described below. Apparently, the accompanying drawings in the following description are merely the embodiments of the present disclosure, and other drawings may be obtained by those of ordinary skill in the art according to these accompanying drawings without creative efforts.
FIG. 1 is a schematic structure view of a low temperature poly-silicon thin film transistor according to an embodiment of the present disclosure.
FIG. 2 is a schematic structure view of a low temperature poly-silicon thin film transistor according to another embodiment of the present disclosure.
FIG. 3 is a flow chart of a method for manufacturing the low temperature poly-silicon thin film transistor illustrated in FIG. 1.
FIG. 4 to FIG. 7 are schematic views of various operations of the method for manufacturing the low temperature poly-silicon thin film transistor illustrated in FIG. 3.
FIG. 8 is a flow chart of a method for manufacturing the low temperature poly-silicon thin film transistor illustrated in FIG. 2.
FIG. 9 is a schematic view of additional operations of the method for manufacturing the low temperature poly-silicon thin film transistor illustrated in FIG. 8 compared with the method for manufacturing the low temperature poly-silicon thin film transistor illustrated in FIG. 3.

### DETAILED DESCRIPTION OF ILLUSTRATED EMBODIMENTS

The technical solutions of the embodiments of the present disclosure will be clearly and completely described with reference to the accompanying drawings.

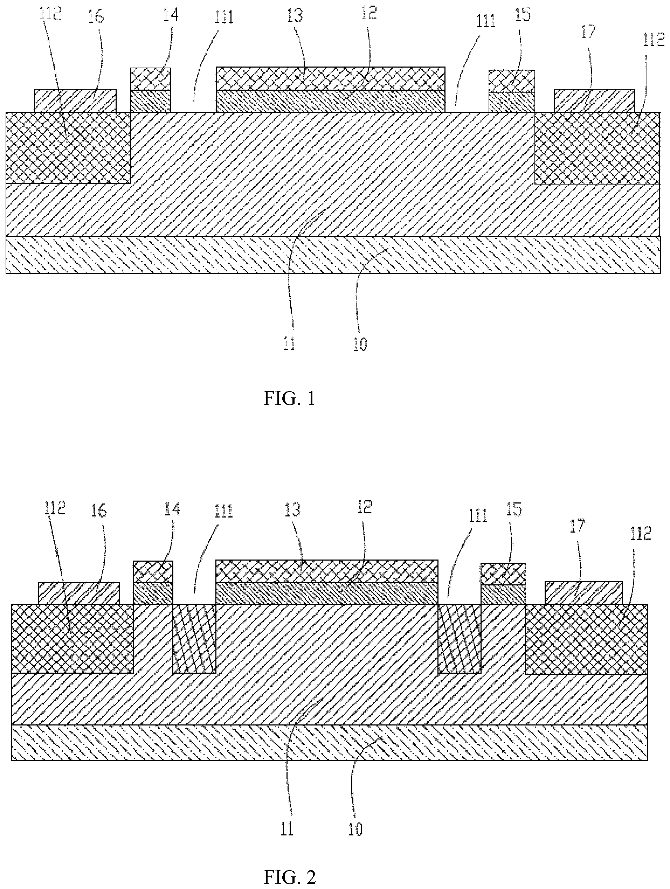

FIG. 1 illustrates a low temperature poly-silicon thin film transistor and an array substrate having the low temperature poly-silicon thin film transistor, operated to be applied in electronic devices having display screens based on liquid crystals, electronic papers, organic light emitting diodes, and the like. The low temperature poly-silicon thin film transistor includes a substrate 10, a poly-silicon layer 11 provided on a surface of the substrate 10, an insulating layer 12, a gate electrode 13, a first control electrode 14, a second control electrode 15, a source electrode 16, and a drain electrode 17. The insulating layer 12 covers the poly-silicon layer 11. The first control electrode 14, the second control electrode 15, and the gate electrode 13 are formed at the insulating layer 12. The first control electrode 14, the gate electrode 13, and the second control electrode 15 are spaced with gaps. The gaps respectively correspond to offset regions 111 of the poly-silicon layer 11. Heavily doped regions 112 are formed at the poly-silicon layer and respectively located at a side of the first control electrode 14 away from the offset regions 111 and a side of the second control electrode 15 away from the offset regions 111. The source electrode 16 and the drain electrode 17 are respectively formed at the two heavily doped regions 112. In the embodiment, since the first control electrode 14 and the second control electrode 15 have appropriate, stable, and sufficient voltages according to actual design requirements, there is no need to be ion implanted in the offset regions 11.

In the embodiment, the orthographic projections of the first control electrode 14, the second control electrode 15 and the gate electrode 13 on the insulating layer 12, overlap the insulating layer 12. The gap between the first control electrode 14 and the gate electrode 13 equals to a gap between the insulating layer 12 under the first control electrode 14 and the insulating layer 12 under the gate electrode 13. The gap between the gate electrode 13 and the second control electrode 15 equals to a gap between the insulating layer 12 under the second control electrode 15 and the insulating layer 12 under the gate electrode 13. The widths of the gaps are respectively equal to the widths of the offset regions 111 located beside two sides of the gate electrode 13. The heavily doped regions 112 extend into the poly-silicon layer 11 and do not penetrate the poly-silicon layer 11. The heavily doped regions 112 may be N-type ion doped region or P-type ion doped region.

In the embodiment, when the low temperature poly-silicon thin film transistor is in an off state, the control electrode 14 is applied with a voltage of 0 V, and the control electrode 15 is applied with a certain voltage. When the low temperature poly-silicon thin film transistor is in an on state, the two control electrodes are applied with a specific voltage. Free charges are induced from the source electrode, to increase the output current of the low temperature poly-silicon thin film transistor. The electrical characteristics of the low temperature poly-silicon thin film transistor are changed by controlling the control electrodes. Furthermore, the first control electrode 14 is connected to an external signal line and the second control electrode 15 is connected to another external signal line or connected to the drain electrode 17. The external signal lines are signal lines provided at edge portions of the substrate which are not used for display. In the embodiment, the first control electrode 14 is connected to the external signal lines, and the second control electrode 15 is connected to the drain electrode 17 through vias or directly connected to the drain electrode 17.

Furthermore, the gate electrode 13, the first control electrode 14, and the second control electrode 15 are formed in the same operations. That is, the gate electrode 13, the first control electrode 14, and the second control electrode 15 are all at the insulating layer 13 and have the same material. Therefore, no process needs to be added.

FIG. 2 illustrates a low temperature poly-silicon thin film transistor according to another embodiment of the present disclosure. In the embodiment, the two offset regions 111 are lightly doped regions. That is, the same N-type ions or P-type ions are doped in the two offset regions 111 as in the heavily doped regions 112. The light doping of the offset region 111a causes a significant increase in the drain current, thereby causing the resistance of the offset region 111a to be further adjusted.

Preferably, the width of the first control electrode 14 is greater than or equal to the width of the gap between the first control electrode 14 and the gate electrode 13. The width of the second control electrode 15 is greater than or equal to the width of the gap between the gate electrode 13 and the second control electrode 15. When the width of the first control electrode 14 is greater than the width of the gap between the first control electrode 14 and the gate electrode 13 and the width of the second control electrode 15 is greater than the width of the gap between the second control electrode 15 and the gate electrode 13, the output current of the low temperature poly-silicon thin film transistor can be further increased. The above gaps and widths can be adjusted according to actual needs such that the output current of the low temperature poly-silicon thin film transistor reaches an optimum value.

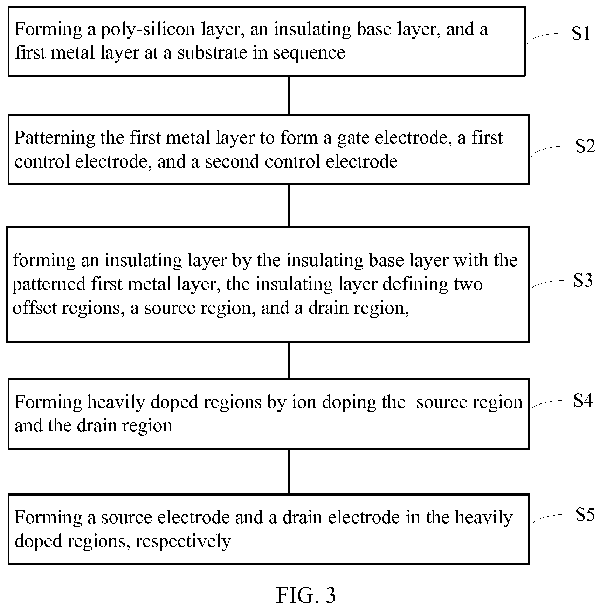

Referring to FIG. 3, a method for manufacturing a low temperature poly-silicon according to an embodiment of the present disclosure includes operations at the following blocks.

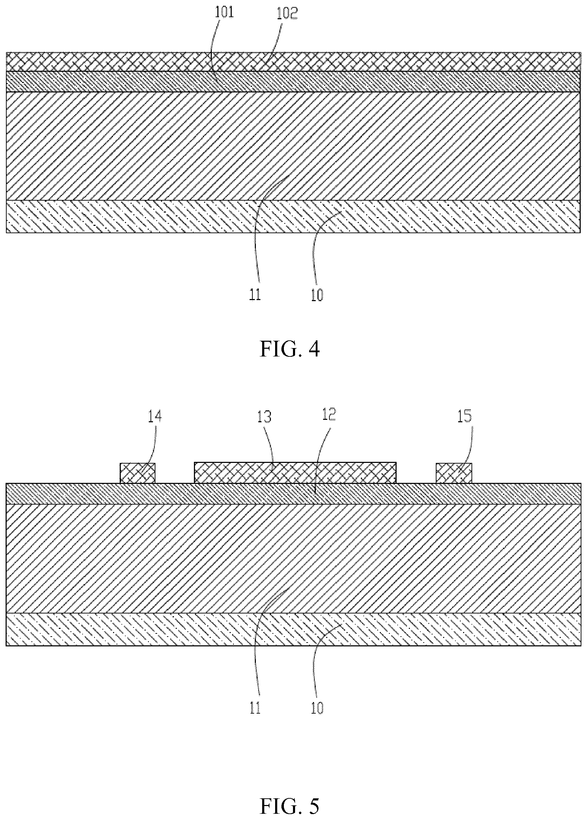

Referring to FIG. 4, at block S1, a poly-silicon layer 11, an insulating base layer 101, and a first metal layer 102 are formed on the substrate 10 in sequence.

Referring to FIG. 5, at block S2, the first metal layer 102 is patterned to form a gate electrode 13, a first control electrode 14, and a second control electrode 15. The first control electrode 14, the second control electrode 15, and the gate electrodes 13 are spaced apart. The first metal layer 102 is patterned by a photo-mask process and an etching process.

At block S3, an insulating layer 12 is formed by the insulating base layer 101 with the patterned first metal layer 102. The insulating layer 12 defines two offset regions 111, a source region 116, and a drain region 117. The offset regions 111 are located at the poly-silicon layer 11. One of the offset regions 111 is located between the first control electrode 14 and the gate electrode 13, and the other of the offset regions 111 is located between the second control electrode 15 and the gate electrode 13. The source region is located at a side of the first control electrode 14 away from the gate electrode 13. The drain region is located at a side of the second control electrode 15 away from the gate electrode 13.

Specifically, the insulating base layer 101 is patterned with the patterned first metal layer 102 as a protective layer. And the offset regions 111, the source region, and the drain region are formed with the position of the first control electrode 14 and the position of the second control electrode 15 as a reference. In this way, self-alignment effects are achieved, and deviations in the offset region 111, the source region, and the drain region are avoided.

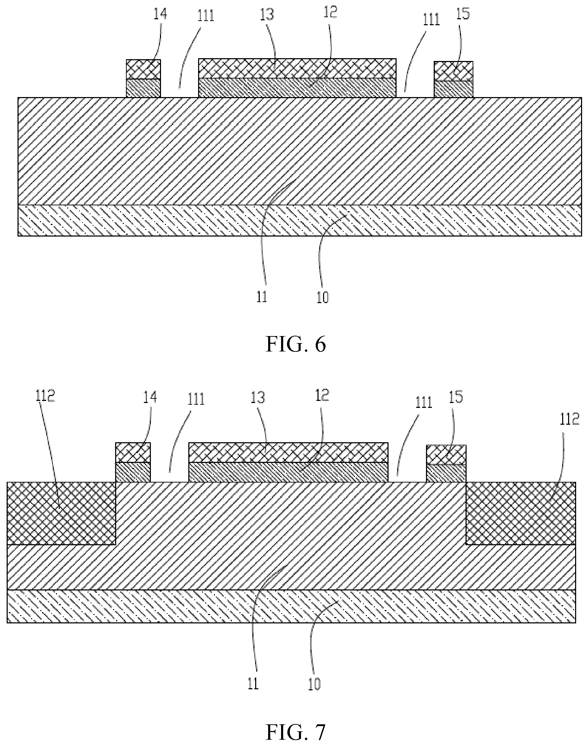

Referring to FIG. 6, at block S4, the source region and the drain region are ion doped to form two heavily doped regions 114. The heavily doped regions 112 may be a N-type ion doped region or a P-type ion doped region.

Referring to FIG. 7, at block S5, a source electrode 16 and a drain electrode 17 are respectively formed in the heavily doped regions 114. Specifically, a second metal layer is formed on the poly-silicon layer 11, the first control electrode 14, and the second control electrode 15. The second metal layer is patterned to form the source electrode 16 and the drain electrode 17.

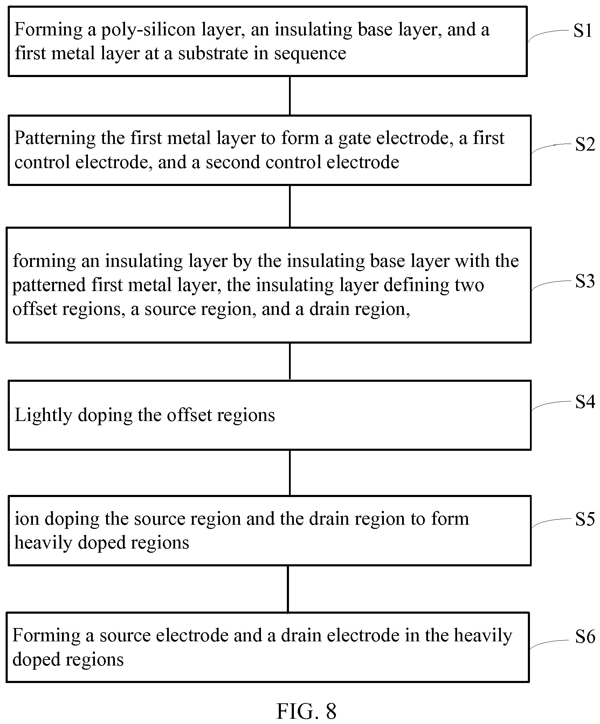

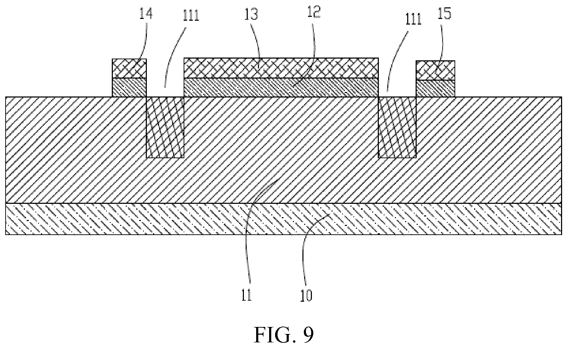

Referring to FIG. 8, FIG. 9, and FIG. 2, in another embodiment, after operations at block 3 of the above embodiment, the method further includes operations at block S4 in which the offset regions 111 are lightly doped to form lightly doped regions, as illustrated in FIG. 9. Then, at block S5, the source region and the drain region are heavily ion doped to form the heavily doped regions 114. At block S6, the source electrode 16 and the drain electrode 17 are formed in the heavily doped region 114, as illustrated in FIG.9.

The low temperature poly-silicon thin film transistor described in the present application simultaneously forms control electrodes on both sides of the gate electrode at the time of forming the gate electrode and the control electrodes reduce the resistance of the low temperature poly-silicon thin film transistor. In this way, not only the electrical characteristics of the thin film transistor may be changed, but also the offset regions, the source region, and the drain region are limited through the two control electrodes. Therefore, the position self-alignment is realized when doping the poly-silicon layer corresponding to the offset regions, the source region, and the drain region. At the same time, the position self-alignments of the source electrode and the drain electrode are realized.

The above is a preferred embodiment of the present disclosure, and it should be noted that those skilled in the art can also make some improvements and modification without departing from the principles of the present disclosure. These improvements and modifications are within the protecting scope of the present disclosure.

## Claims

1. A low temperature poly-silicon thin film transistor, comprising:
a substrate;
a poly-silicon layer formed at a surface of the substrate;
an insulating layer covering the poly-silicon layer;
a first control electrode, a second control electrode, and a gate electrode formed at the insulating layer, a gap defined between the first control electrode and the gate electrode, a gap defined between the second control electrode and the gate electrode, and the gaps respectively correspond to two offset regions of the poly-silicon layer;
two heavily doped regions formed at the poly-silicon layer and respectively located at a side of the first control electrode away from the offset regions and a side of the second control electrode away from the offset regions; and
a source electrode and a drain electrode respectively formed at the two heavily doped regions.

2. The low temperature poly-silicon thin film transistor of claim 1, wherein the two offset regions are lightly doped regions.

3. The low temperature poly-silicon thin film transistor of claim 1 or 2, wherein the first control electrode is connected to an external signal line, and the second control electrode is connected to another external signal line or connected to the drain electrode.

4. The low temperature poly-silicon thin film transistor of claim 1, wherein the gate electrode, the first control electrode, and the second control electrode are formed in the same operations.

5. The low temperature poly-silicon thin film transistor of claim 1, wherein a width of the first control electrode is greater than or equal to a width of the gap between the first control electrode and the gate electrode, and a width of the second control electrode is greater than or equal to a width of the gap between the second control electrode and the gate electrode.

6. A method for manufacturing a low temperature poly-silicon thin film transistor, comprising:
forming a poly-silicon layer, an insulating base layer, and a first metal layer on a substrate in sequence;
patterning the first metal layer to form a gate electrode, a first control electrode, and a second control electrode, and the gate electrode, the first control electrode and the gate electrode spaced apart from each other, and the second control electrode and the gate electrode spaced apart from each other;
forming an insulating layer by the insulating base layer with the patterned first metal layer, the insulating layer defining two offset regions, a source region, and a drain region, the offset regions located at the poly-silicon layer, one of the offset regions located between the first control electrode and the gate electrode, the other of the offset regions located between the second control electrode and the gate electrode, the source region and the drain region respectively located a side of the first control electrode away from the offset regions and a side of the second control electrode away from the offset regions;
ion doping the source region and the drain region to form heavily doped regions; and
forming a source electrode and a drain electrode in the heavily doped regions, respectively.

7. The method of claim 6, wherein the forming an insulating layer by the insulating base layer with the patterned first metal layer, the insulating layer defining two offset regions, a source region, and a drain region, comprising:
defining the offset regions, the source region, and the drain region with the position of the first control electrode and the position of the second control electrode as a reference.

8. The method of claim 6, further comprising lightly doping the offset regions before ion doping the source region and the drain region, to form heavily doped regions.

9. The method of claim 6, wherein the low temperature poly-silicon thin film transistor further forms external signal lines operated to connect the first control electrode, or to connect the first control electrode and the second control electrode.

10. A thin film transistor array substrate, comprising:
a low temperature poly-silicon thin film transistor, the low temperature poly-silicon thin film transistor comprising:
a substrate;
a poly-silicon layer formed at a surface of the substrate;
an insulating layer covering the poly-silicon layer;
a first control electrode, a second control electrode, and a gate electrode formed at the insulating layer, a gap defined between the first control electrode and the gate electrode, a gap defined between the second control electrode and the gate electrode, and the gaps respectively correspond to two offset regions of the poly-silicon layer;
two heavily doped regions formed at the poly-silicon layer and respectively located at a side of the first control electrode away from the offset regions and a side of the second control electrode away from the offset regions; and
a source electrode and a drain electrode respectively formed at the two heavily doped regions.

11. The thin film transistor of claim 10, wherein the two offset regions are lightly doped regions.

12. The thin film transistor of claim 10 or claim 11, wherein the first control electrode is connected to an external signal line, and the second control electrode is connected to another external signal line or connected to the drain electrode.

13. The thin film transistor of claim 10, wherein the gate electrode, the first control electrode, and the second control electrode are formed in the same operations.

14. The thin film transistor of claim 10, wherein a width of the first control electrode is greater than or equal to a width of the gap between the first control electrode and the gate electrode, and a width of the second control electrode is greater than or equal to a width of the gap between the second control electrode and the gate electrode.
